# EUROPEAN PATENT SPECIFICATION

(11) **EP 4 262 333 B1**
(45) Date of publication and mention of the grant of the patent: **04.03.2026**
(21) Application number: 23165531.7
(22) Date of filing: 30.03.2023
(51) Int. Cl.: H05K 9/00

(54) **ELECTRONIC DEVICE**
ELEKTRONISCHE VORRICHTUNG
DISPOSITIF ÉLECTRONIQUE

(30) Priority: 11.04.2022 JP 2022065380
(43) Date of publication of application: 18.10.2023
(73) Proprietor: Sony Interactive Entertainment Inc., Tokyo 108-0075 (JP)
(72) Inventor: TSUCHIDA, Shinya, Minato-ku, 108-0075 (JP); ITO, Katsushi, Minato-ku, 108-0075 (JP); SUGAWARA, Nobuyuki, Minato-ku, 108-0075 (JP); NOZAWA, Tetsufumi, Minato-ku, 108-0075 (JP)
(74) Representative: D Young & Co LLP

(56) References cited:
- GB-A- 2 292 483
- JP-A- 2013 038 243
- US-A1- 2017 290 140
- US-A1- 2018 255 633
- US-A1- 2022 009 428

## Description

### BACKGROUND

The present disclosure relates to an electronic device.

Hitherto, in electronic devices, noise countermeasures (electro magnetic interference (EMI) countermeasures) for shielding noise radiated from chips or data transmission lines mounted on circuit boards have been taken. In an electronic device described in Japanese Patent Laid-open No. 2018-148026 (hereinafter, referred to as Patent Document 1), with an edge of a board shield, which covers a circuit board, being in contact with a ground pattern provided in an outer peripheral portion of the circuit board, noise is prevented from leaking to the outside of the circuit board shield. Another previously proposed arrangement is disclosed in GB 2 292 483 A.

### SUMMARY

The invention is defined by the appended claims.

In the structure of Patent Document 1 described above, since the ground pattern needs to be provided over the entire periphery of the outer peripheral portion of the circuit board, the mounting region for the electronic components is narrow due to the region of the ground pattern.

It is desirable to provide an electronic device that can have a narrowed region of a ground pattern on a circuit board.

According to an embodiment of the present disclosure, there is provided an electronic device including a circuit board having a first surface and a second surface, a first member for covering the first surface to function as a shield of the circuit board, and a second member placed on a side of the second surface. The first member has a first encompassing region surrounding an electronic component mounted on the first surface. The first encompassing region has, in at least a portion thereof, a first outer region located on an outer side of an outer edge of the circuit board. The second member has a second outer region located on the outer side of the outer edge of the circuit board. One of the first outer region and the second outer region has at least one outer fixed portion fixed to another of the first outer region and the second outer region and at least one projection located away from the at least one outer fixed portion in a direction along the outer edge of the circuit board. The first member and the second member are in contact with each other with the at least one outer fixed portion and the at least one projection. With this, the ground pattern on the circuit board can have a reduced region size. Furthermore, the first encompassing region has, in at least a portion thereof, a first inner region located on an inner side of another outer edge of the circuit board, wherein the first inner region is in contact with a ground pattern formed on the first surface of the circuit board, and wherein the first inner region has at least one inner fixed portion for fixing to the circuit board.

### BRIEF DESCRIPTION OF THE DRAWINGS

FIG. 1A is a plan view of a circuit board unit that is provided inside an electronic device according to an exemplary embodiment of the present disclosure;
FIG. 1B is a bottom view of the circuit board unit.
FIG. 2A is an exploded perspective view of the circuit board unit;
FIG. 2B is another exploded perspective view of the circuit board unit;
FIG. 2C is a sectional view taken along the line IIC-IIC of FIG. 1A;
FIG. 2D is a sectional view taken along the line IID-IID of FIG. 1A;
FIG. 3A is a plan view illustrating the circuit board unit from which an upper board shield has been removed;
FIG. 3B is a bottom view illustrating the circuit board unit from which a lower board shield has been removed;
FIG. 4 is a sectional view taken along the line IV-IV of FIG. 1A;
FIG. 5 is a sectional view taken along the line V-V of FIG. 1A;
FIG. 6 is a schematic diagram illustrating the cross sections of outer contact regions of the upper board shield and the lower board shield; and
FIG. 7 is a partial enlarged view of FIG. 3A and a view illustrating an upper ground pattern of a circuit board and an outer contact region of the lower board shield.

### DETAILED DESCRIPTION OF THE PREFERRED EMBODIMENT

### [1. Overview of Circuit Board Unit]

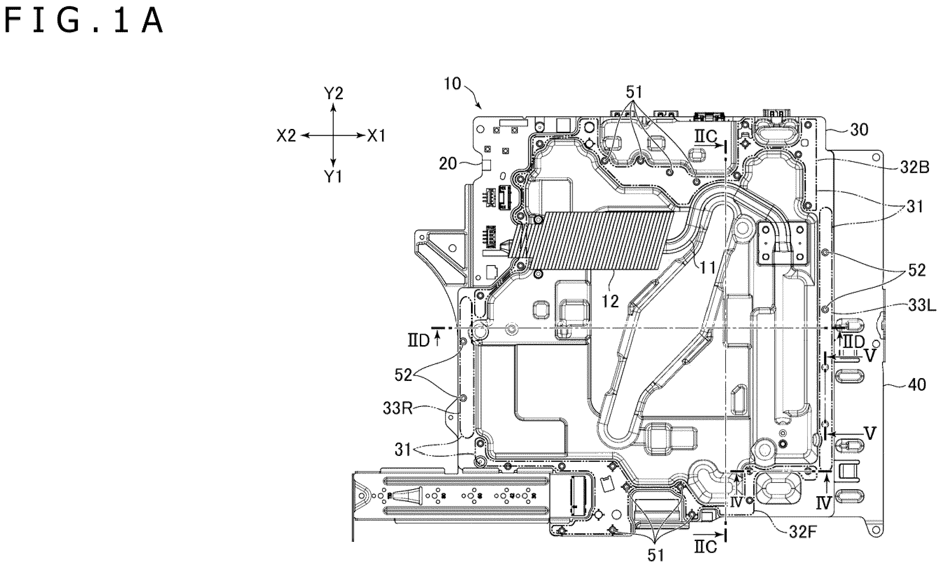

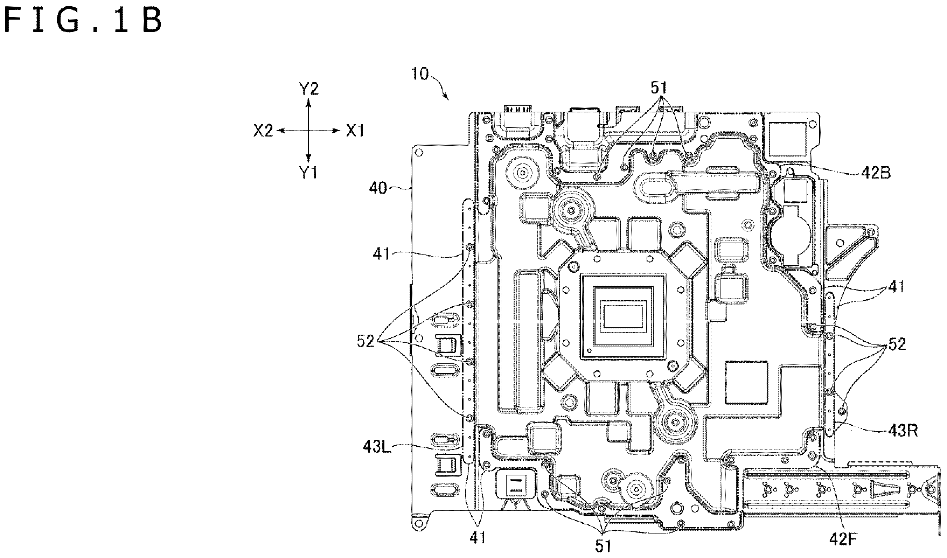

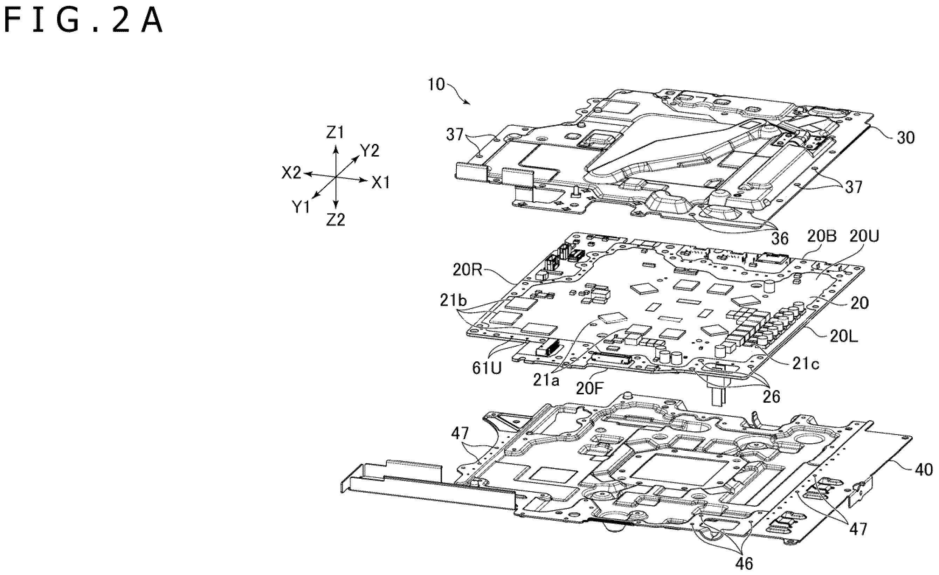

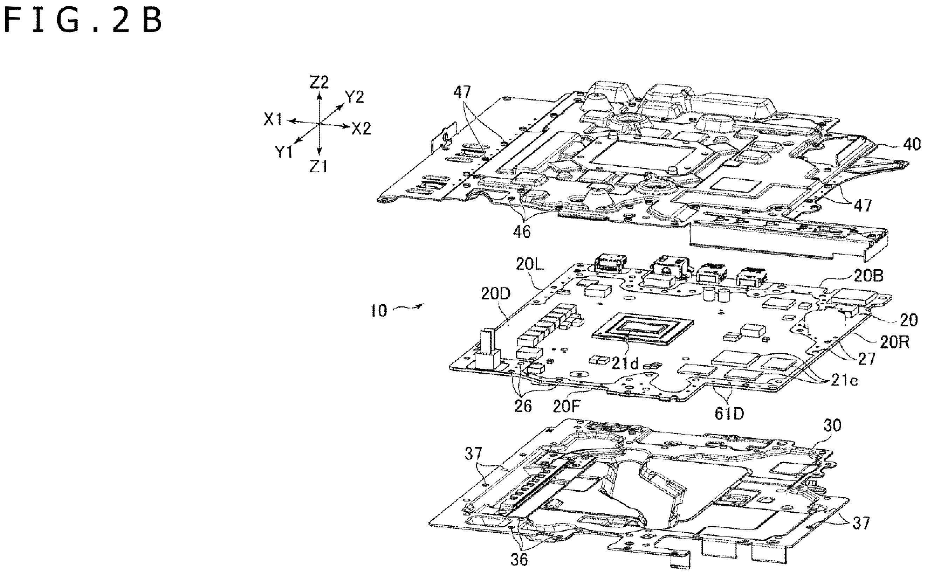

FIG. 1A is a plan view illustrating the front side of a circuit board unit 10 that is provided inside an electronic device according to an exemplary embodiment of the present disclosure. FIG. 1B is a bottom view illustrating the back side of the circuit board unit 10. FIG. 2A and FIG. 2B are exploded perspective views illustrating components of the circuit board unit 10. As illustrated in FIG. 1A and FIG. 1B, the circuit board unit 10 includes a circuit board 20, a first circuit board shield 30 (first member), and a second circuit board shield 40 (second member). The circuit board 20 has a first surface 20U (see FIG. 2A) and a second surface 20D (see FIG. 2B). The first circuit board shield 30 covers the first surface 20U of the circuit board 20. The second circuit board shield 40 covers the second surface 20D of the circuit board 20. As illustrated in FIG. 1A, the circuit board unit 10 has mounted thereon a heat pipe 11 and a heat sink 12.

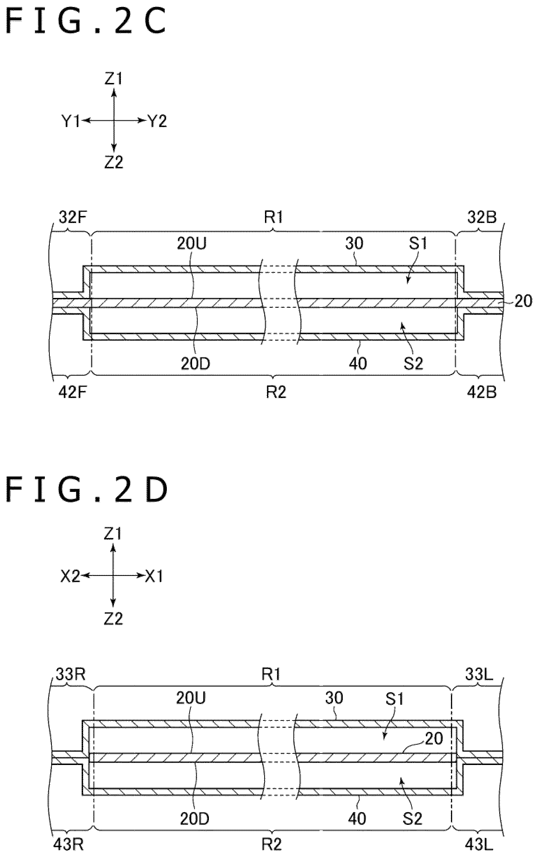

In the following description, a Z1 direction and a Z2 direction in the Z axis illustrated in FIG. 2 and the like are referred to as upward and downward, respectively. Then, the first surface 20U of the circuit board 20 is referred to as an upper surface 20U, and the second surface 20D of the circuit board 20 is referred to as a lower surface 20D. The first circuit board shield 30 is referred to as an upper board shield 30, and the second circuit board shield 40 is referred to as a lower board shield 40. Further, in the following description, an example in which the circuit board 20 has outer edges 20F and 20B along the X axis illustrated in FIG. 2 and the like and outer edges 20L and 20R along the Y axis is described. An X1 direction and an X2 direction in the X axis illustrated in FIG. 2 and the like are referred to as a left direction and a right direction, respectively, and a Y1 direction and a Y2 direction in the Y axis are referred to as forward and backward, respectively. The front-side outer edge 20F, the back-side outer edge 20B, the left-side outer edge 20L, and the right-side outer edge 20R of the circuit board 20 are sometimes referred to as a front edge 20F, a back edge 20B, a left edge 20L, and a right edge 20R, respectively. However, these directions and placement positions are defined to describe the shapes and relative positional relations of elements, such as parts, members, and portions, of the circuit board unit 10 and not intended to limit the posture of the circuit board unit 10 in the electronic device.

### [2. Internal Structure of Circuit Board Unit]

As illustrated in FIG. 2A, a plurality of electronic components such as integrated circuit chips 21a and 21b and a transistor 21c are mounted on the upper surface 20U of the circuit board 20. Further, as illustrated in FIG. 2B, a plurality of electronic components such as integrated circuit chips 21d and 21e are mounted on the lower surface 20D of the circuit board 20. Note that, in the example illustrated in FIG. 2B, the lower surface of the integrated circuit chip 21d is covered by a thermally conductive member.

The upper board shield 30 and the lower board shield 40 prevent noise such as electromagnetic waves generated on the circuit board 20 from leaking to the outside of the circuit board unit 10. The upper board shield 30 and the lower board shield 40 are produced by performing sheet metal processing such as drawing on a conductive metal sheet such as an iron or aluminum sheet. The upper board shield 30 is fixed to the lower board shield 40 with a plurality of screws 51 and 52. The circuit board 20 is fixed to the upper board shield 30 and the lower board shield 40 with the plurality of screws 51. Note that the circuit board 20 may be fixed to the board shields 30 and 40 with rivets or the like instead of the screws 51 and 52.

FIG. 2C is a sectional view taken along the line IIC-IIC of FIG. 1A. FIG. 2D is a sectional view taken along the line IID-IID of FIG. 1A. As illustrated in FIG. 2C and FIG. 2D, above the circuit board 20, a shielded space S1, which is a space closed by the circuit board 20 and the upper board shield 30, is formed. Further, under the circuit board 20, a shielded space S2, which is a space closed by the circuit board 20 and the lower board shield 40, is formed.

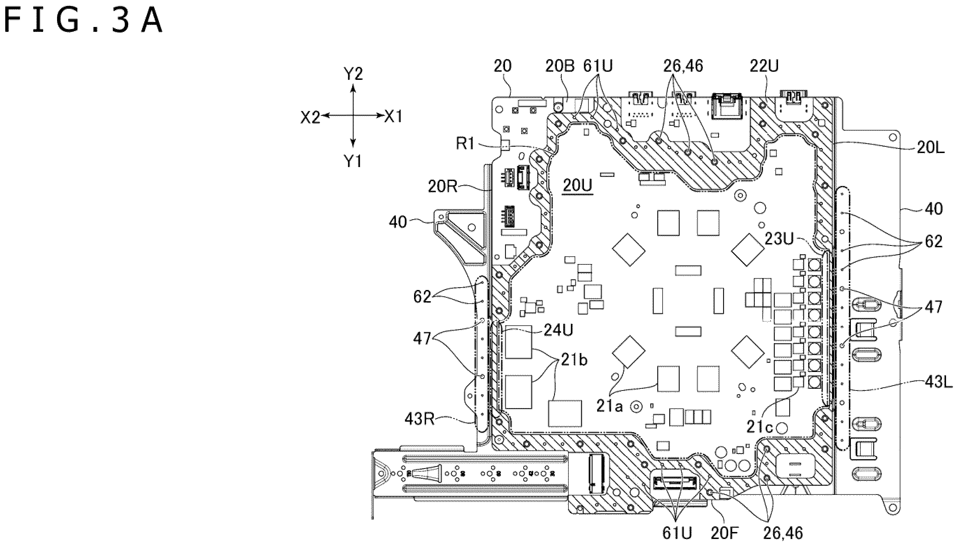

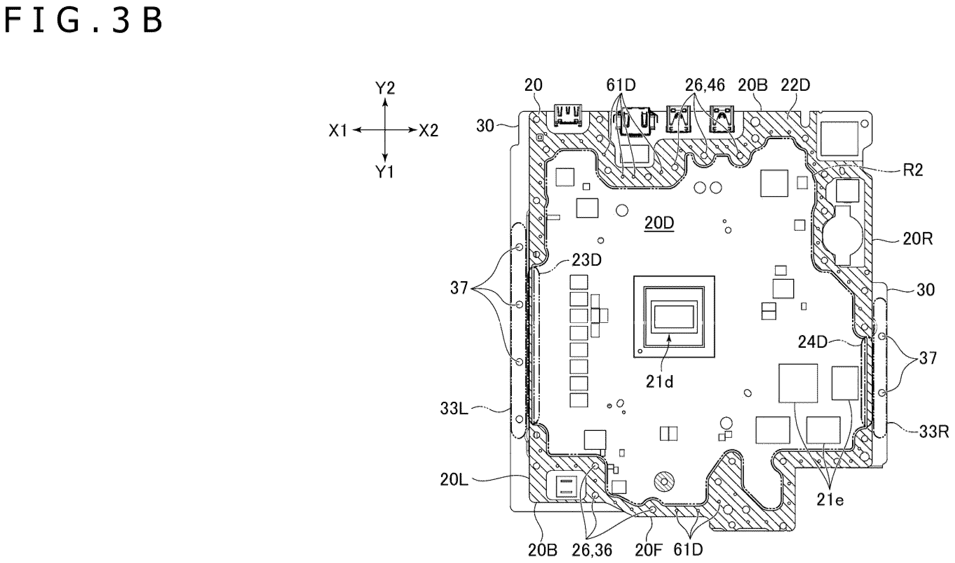

FIG. 3A is a plan view illustrating the circuit board unit 10 illustrated in FIG. 1A from which the upper board shield 30 has been removed. FIG. 3B is a bottom view illustrating the circuit board unit 10 illustrated in FIG. 1B from which the lower board shield 40 has been removed. In the respective hatched portions of FIG. 3A and FIG. 3B, corresponding ground patterns 22U and 22D that serve as a reference potential for an electronic circuit are formed.

As illustrated in FIG. 3A, the upper ground pattern 22U (first ground pattern) formed on the upper surface 20U of the circuit board 20 surrounds, on the upper surface 20U, an upper mounting region R1 in which the plurality of electronic components such as the integrated circuit chips 21a and 21b and the transistor 21c are mounted. The ground pattern 22U has a linear shape with a predetermined width and continuously surrounds the mounting region R1. At least a portion of the ground pattern 22U is formed along the edges of the circuit board 20. Further, as illustrated in FIG. 3B, the lower ground pattern 22D (second ground pattern) formed on the lower surface 20D of the circuit board 20 surrounds, on the lower surface 20D, a lower mounting region R2 in which the plurality of electronic components such as the integrated circuit chips 21d and 21e are mounted.

As illustrated in FIG. 1A and FIG. 2A, the upper board shield 30 has an upper encompassing region 31 (first encompassing region) (see FIG. 1A) surrounding the plurality of electronic components such as the integrated circuit chips 21a and 21b and the transistor 21c (see FIG. 2A) mounted on the upper surface 20U of the circuit board 20. Similarly, as illustrated in FIG. 1B and FIG. 2B, the lower board shield 40 has a lower encompassing region 41 (second encompassing region) (see FIG. 1B) surrounding the plurality of electronic components such as the integrated circuit chips 21d and 21e (see FIG. 2B) mounted on the lower surface 20D of the circuit board 20. In the plan view of the circuit board unit 10, the upper encompassing region 31 of the upper board shield 30 has a portion overlapping the circuit board 20 and a portion overlapping the lower board shield 40. Further, the lower encompassing region 41 of the lower board shield 40 has a portion overlapping the circuit board 20 and a portion overlapping the upper board shield 30. At least a portion of the upper encompassing region 31 overlaps the lower encompassing region 41.

As illustrated in FIG. 1A, the upper encompassing region 31 of the upper board shield 30 has inner contact regions 32F and 32B (first inner contact regions) located on the inner sides of the outer edges of the circuit board 20 and outer contact regions 33L and 33R (first outer contact regions) located on the outer sides of the outer edges of the circuit board 20. Similarly, as illustrated in FIG. 1B, the lower encompassing region 41 of the lower board shield 40 has inner contact regions 42F and 42B (second inner contact regions) located on the inner sides of the outer edges of the circuit board 20 and outer contact regions 43L and 43R (second outer contact regions) located on the outer sides of the outer edges of the circuit board 20.

As illustrated in FIG. 1A and FIG. 2A, in the upper encompassing region 31 of the upper board shield 30, the inner contact region 32F is formed along the front edge 20F of the circuit board 20, and the inner contact region 32B is formed along the back edge 20B of the circuit board 20. Further, in the upper encompassing region 31 of the upper board shield 30, the outer contact region 33L is formed along the left edge 20L of the circuit board 20, and the outer contact region 33R is formed along the right edge 20R of the circuit board 20. The inner contact regions 32F and 32B are in contact with the outer contact regions 33L and 33R. Then, the inner contact regions 32F and 32B and the outer contact regions 33L and 33R surround the entire periphery of the upper mounting region R1 (see FIG. 3A), in which the plurality of electronic components that are noise generation sources are mounted, on the upper surface 20U of the circuit board 20. The inner contact regions 32F and 32B and the outer contact regions 33L and 33R are formed outward from the positions of edges of the upper mounting region R1 to have predetermined widths and continuously formed to surround the entire periphery of the upper mounting region R1.

Further, as illustrated in FIG. 1B and FIG. 2B, in the lower encompassing region 41 of the lower board shield 40, the inner contact region 42F is formed along the front edge 20F of the circuit board 20, the inner contact region 42B is formed along the back edge 20B of the circuit board 20, the outer contact region 43L is formed along the left edge 20L of the circuit board 20, and the outer contact region 43R is formed along the right edge 20R of the circuit board 20. The inner contact regions 42F and 42B are in contact with the outer contact regions 43L and 43R. The inner contact regions 42F and 42B and the outer contact regions 43L and 43R surround the entire periphery of the lower mounting region R2 (see FIG. 3B), in which the plurality of electronic components that are noise generation sources are mounted, on the lower surface 20D of the circuit board 20. The inner contact regions 42F and 42B and the outer contact regions 43L and 43R are formed outward from the positions of edges of the lower mounting region R2 to have predetermined widths and continuously formed to surround the entire periphery of the lower mounting region R2.

### [3. Noise Shielding Structure Inside Circuit Board]

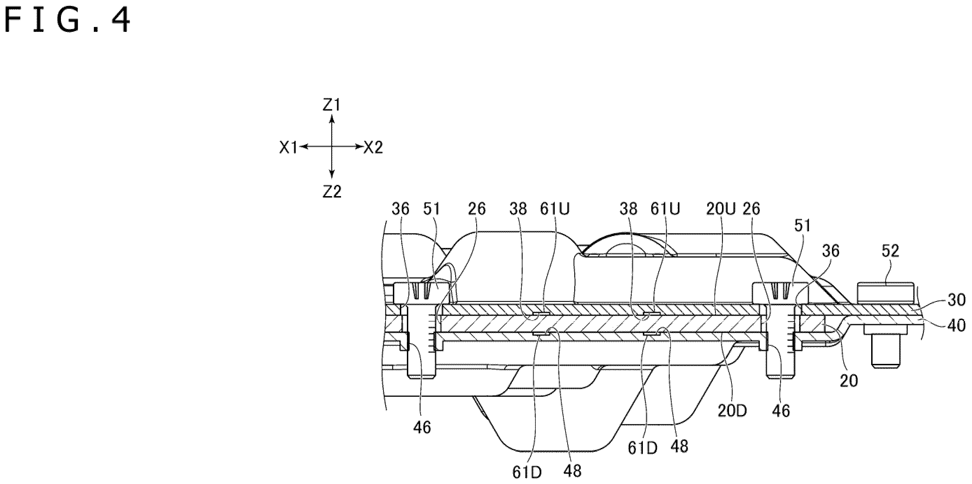

FIG. 4 is a sectional view taken along the line IV-IV of FIG. 1A. The inner contact region 32F (see FIG. 1A) of the upper board shield 30 is in contact with the upper surface 20U of the circuit board 20 as illustrated in FIG. 4. The inner contact region 32B of the upper board shield 30 is also in contact with the upper surface 20U of the circuit board 20. More specifically, the inner contact regions 32F and 32B are in contact with the upper ground pattern 22U (see the hatched portion of FIG. 3A) formed on the upper surface 20U of the circuit board 20. As illustrated in FIG. 2C and FIG. 4, with the inner contact regions 32F and 32B of the upper board shield 30 being in contact with the ground pattern 22U of the circuit board 20, noise such as electromagnetic waves generated on the upper surface 20U of the circuit board 20 can be prevented from leaking to the outside of the shielded space S1 closed by the upper surface 20U and the upper board shield 30.

Further, as illustrated in FIG. 4, the inner contact regions 42F and 42B (see FIG. 1B) of the lower board shield 40 are in contact with the lower ground pattern 22D (see the hatched portion of FIG. 3B) formed on the lower surface 20D of the circuit board 20. As illustrated in FIG. 2C and FIG. 4, with the inner contact regions 42F and 42B of the lower board shield 40 being in contact with the ground pattern 22D of the circuit board 20, noise generated on the lower surface 20D of the circuit board 20 can be prevented from leaking to the outside of the shielded space S2 closed by the lower surface 20D and the lower board shield 40.

The inner contact regions 32F and 32B of the upper board shield 30 have, as illustrated in FIG. 2A, FIG. 2B, and FIG. 4, a plurality of mounting holes 36 (inner fixed portions) for fixing to the circuit board 20. Similarly, the inner contact regions 42F and 42B of the lower board shield 40 have a plurality of mounting holes 46 for fixing to the circuit board 20. The ground patterns 22U and 22D of the circuit board 20 have a plurality of mounting holes 26. As illustrated in FIG. 4, the positions of the mounting holes 36, 26, and 46, which are provided in the upper board shield 30, the circuit board 20, and the lower board shield 40, respectively, match each other, and the single screw 51 is mounted in these mounting holes 36, 26, and 46. In this way, with the upper board shield 30, the circuit board 20, and the lower board shield 40 tightened together with the single screw, the board shields 30 and 40 are in contact with the ground patterns 22U and 22D of the circuit board 20 at the positions of the mounting holes 36, 26, and 46, so that enhanced shielding performance for noise generated on the circuit board 20 can be provided.

As illustrated in FIG. 3A, the upper ground pattern 22U formed on the upper surface 20U of the circuit board 20 has a plurality of projections 61U protruding upward. The position of the projection 61U is located away from the mounting hole 26 provided in the upper ground pattern 22U, in the extending direction of the upper ground pattern 22U. In other words, in the extending direction of the upper ground pattern 22U, the projection 61U is formed between the adjacent two mounting holes 26. Similarly, as illustrated in FIG. 3B, the lower ground pattern 22D formed on the lower surface 20D of the circuit board 20 has a plurality of projections 61D protruding downward. The position of the projection 61D is located away from the mounting hole 26 provided in the lower ground pattern 22D, in the extending direction of the lower ground pattern 22D. The projections 61U and 61D may be formed by putting a conductive member such as a solder on the ground patterns 22U and 22D. The number of the projections 61U and 61D formed between the adjacent mounting holes 26 is preferably two or less.

Enhanced shielding performance for noise generated on the circuit board 20 can be provided. Further, the projections 61U and 61D may be formed by performing sheet metal processing on the board shields 30 and 40. In this manner, the projections 61U and 61D can easily be formed inside the circuit board 20.

As illustrated in FIG. 1A and FIG. 4, the inner contact regions 32F and 32B of the upper board shield 30 have inner contact portions 38 (first contact portions) in contact with the upper ground pattern 22U via the projections 61U. Similarly, the inner contact regions 42F and 42B of the lower board shield 40 (see FIG. 1B) have inner contact portions 48 (second contact portions) in contact with the lower ground pattern 22D via the projections 61D. In this manner, at the positions of the projections 61U and 61D, the board shields 30 and 40 are in contact with the ground patterns 22U and 22D of the circuit board 20 with enough stability, so that enhanced shielding performance for noise generated on the circuit board 20 can be provided.

In the following description, the positions of the mounting holes 26, 36, and 46 of the circuit board 20 and the board shields 30 and 40 into which the screw 51 is inserted and the positions at which the projections 61U and 61D are provided are also referred to as inner contact points. The distance between adjacent two of the plurality of inner contact points provided on the ground patterns 22U and 22D of the circuit board 20 is desirably determined on the basis of the wavelength of noise, the leakage of which to the outside is to be prevented.

In the inner contact regions 32F and 32B of the upper board shield 30, the inner contact portion 38 in contact with the projection 61U is located away from the mounting hole 36 in the extending direction of the inner contact regions 32F and 32B. Further, the inner contact portion 38 in contact with one of the adjacent two projections 61U is located away from the inner contact portion 38 in contact with the other projection 61U, in the extending direction of the inner contact regions 32F and 32B. Similarly, in the inner contact regions 42F and 42B of the lower board shield 40, the inner contact portion 48 in contact with the projection 61D is located away from the mounting hole 46 in the extending direction of the inner contact regions 42F and 42B, and the inner contact portion 48 in contact with one of the adjacent two projections 61D is located away from the inner contact portion 48 in contact with the other projection 61D, in the extending direction of the inner contact regions 42F and 42B. Then, the distance between those (that is, the distance between the adjacent two inner contact points) may be set to a value less than a third of the wavelength of noise that the board shields 30 and 40 shield, more preferably, less than a quarter of the wavelength. Further, the distance between every adjacent two inner contact points is preferably 20 mm. With this, the leakage of noise in frequency bands that are used for wireless communications and the like can effectively be prevented. The distance between every adjacent two inner contact points is preferably 15 mm or less. The distance between every adjacent two contact points is further preferably 10 mm or less.

In FIG. 3A and FIG. 3B, the mounting holes 26, 36, and 46 are indicated by the circles having substantially the same size, and the projections 61U and 61D are indicated by the circles smaller than the mounting holes 26, 36, and 46. As illustrated in FIG. 3A and FIG. 3B, the distance between every adjacent two of the inner contact points at the positions of the plurality of mounting holes 26, 36, and 46 provided in the inner contact regions 32F, 32B, 42F, and 42B and the plurality of projections 61U and 61D is set to 20 mm or less (a value less than a third of the wavelength corresponding to 5 GHz). In this manner, noise can more effectively be prevented from leaking from the inner contact regions 32F, 32B, 42F, and 42B.

### [4. Noise Shielding Structure Outside Circuit Board]

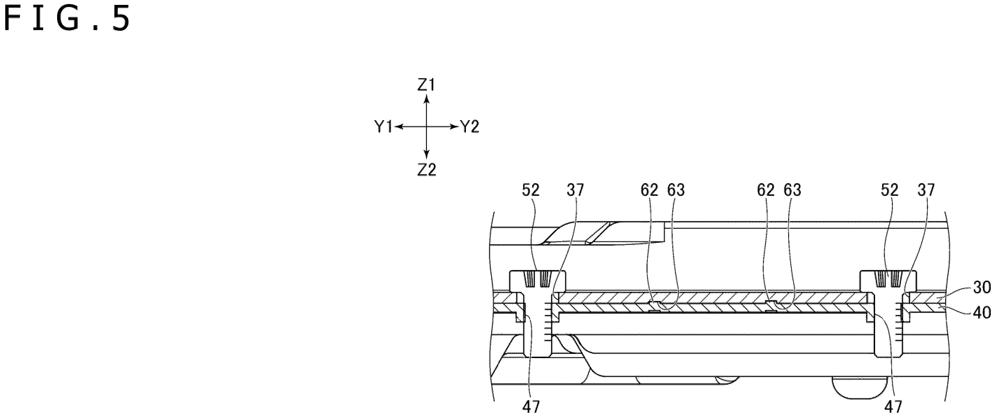

FIG. 5 is a sectional view taken along the line V-V of FIG. 1A. The outer contact region 33L (see FIG. 1A) of the upper board shield 30 and the outer contact region 43L (see FIG. 1B) of the lower board shield 40 are in contact with each other as illustrated in FIG. 2D and FIG. 5. Further, the outer contact region 33R of the upper board shield 30 and the outer contact region 43R of the lower board shield 40 are also in contact with each other. In this way, with the outer contact regions 33L and 33R of the upper board shield 30 being in contact with the outer contact regions 43L and 43R of the lower board shield 40, noise generated on the circuit board 20 can be prevented from leaking to the outside of the shielded spaces S1 and S2 closed by the board shields 30 and 40. That is, the regions for shielding noise can be formed outside the circuit board 20, so that the ground patterns 22U and 22D inside the circuit board 20 can have narrowed regions.

As illustrated in FIG. 3A, on the upper surface 20U of the circuit board 20, there are a region 23U in which the upper ground pattern 22U is not formed along the left edge 20L of the circuit board 20 and a region 24U in which the mounting hole 26 and the projection 61U of the upper ground pattern 22U are not formed along the right edge 20R of the circuit board 20. Since noise traveling to the regions 23U and 24U is shielded by the outer contact regions 33L and 33R of the upper board shield 30, the noise can be prevented from leaking to the outside of the shielded space S1. Moreover, the upper ground pattern 22U can have a narrowed region, so that the upper mounting region R1, in which the electronic components are mounted, can be expanded to the vicinity of the edges (the left edge 20L and the right edge 20R of FIG. 3A) of the circuit board 20.

Further, as illustrated in FIG. 3B, on the lower surface 20D of the circuit board 20, there are a region 23D in which the lower ground pattern 22D is not formed along the left edge 20L of the circuit board 20 and a region 24D in which the mounting hole 26 and the projection 61D of the lower ground pattern 22D are not formed along the right edge 20R of the circuit board 20. Further, as illustrated in FIG. 2D, since noise traveling to the regions 23D and 24D is shielded by the outer contact regions 43L and 43R of the lower board shield 40, the noise can be prevented from leaking to the outside of the shielded space S2. Moreover, the lower ground pattern 22D can have a narrowed region, so that the lower mounting region R2, in which the electronic components are mounted, can be expanded to the vicinity of the edges (the left edge 20L and the right edge 20R of FIG. 3B) of the circuit board 20.

As illustrated in FIG. 3B and FIG. 5, the outer contact regions 33L and 33R of the upper board shield 30 have a plurality of mounting holes 37 (outer fixed portions) for fixing to the outer contact regions 43L and 43R of the lower board shield 40. Further, as illustrated in FIG. 3A and FIG. 5, the outer contact regions 43L and 43R of the lower board shield 40 have a plurality of mounting holes 47 for fixing to the outer contact regions 33L and 33R of the upper board shield 30. As illustrated in FIG. 5, the positions of the mounting holes 37 and 47 provided in the board shields 30 and 40, respectively, match each other, and the single screw 52 is mounted in these mounting holes 37 and 47. In this way, with the board shields 30 and 40 being tightened together with the single screw, the upper board shield 30 is in contact with the lower board shield 40 at the positions of the mounting holes 37 and 47, so that enhanced shielding performance for noise generated on the circuit board 20 can be provided.

As illustrated in FIG. 3A, the outer contact regions 43L and 43R of the lower board shield 40 have a plurality of projections 62 (outer contact projections) protruding upward. The position of the projection 62 is located away from the mounting holes 47 formed in the outer contact regions 43L and 43R in the direction along the left edge 20L and the right edge 20R of the circuit board 20 (the extending direction of the outer contact regions 43L and 43R). In other words, the projection 62 is formed between the two mounting holes 47 in the extending direction of the outer contact regions 43L and 43R. The projections 62 of the lower board shield 40 are formed by performing sheet metal processing on the outer contact regions 43L and 43R. In this manner, the projections 62 are easily formed on the lower board shield 40. The present disclosure is not limited to this, and the projections 62 may be formed by putting a conductive member such as a solder on the outer contact regions 43L and 43R. The number of the projections 62 that are formed between the adjacent mounting holes 47 is preferably two or less.

As illustrated in FIG. 1A and FIG. 5, the outer contact regions 33L and 33R of the upper board shield 30 have outer contact portions 63 in contact with the projections 62 of the lower board shield 40. With this, the upper board shield 30 is in contact with the lower board shield 40 at the positions of the projections 62, so that enhanced shielding performance for noise generated on the circuit board 20 can be provided.

As illustrated in FIG. 2C and FIG. 2D, the shielded space S1 on the upper surface 20U side of the circuit board 20 is formed with the circuit board 20 (more specifically, the upper ground pattern 22U) being in contact with the inner contact regions 32F and 32B of the upper board shield 30, and the outer contact regions 33L and 33R of the upper board shield 30 being in contact with the outer contact regions 43L and 43R of the lower board shield 40. Similarly, the shielded space S2 on the lower surface 20D side of the circuit board 20 is formed with the circuit board 20 (more specifically, the lower ground pattern 22D) being in contact with the inner contact regions 42F and 42B of the lower board shield 40, and the outer contact regions 33L and 33R of the upper board shield 30 being in contact with the outer contact regions 43L and 43R of the lower board shield 40. In short, as illustrated in FIG. 2D, the projections 62 formed in the outer contact regions 43L and 43R of the lower board shield 40 and the outer contact portions 63 provided in the outer contact regions 33L and 33R of the upper board shield 30 are used in common as measures against noise for the shielded spaces S1 and S2 formed above and under the circuit board 20, respectively. With the outer contact regions 33L and 43L of the board shields 30 and 40 being in contact with each other via the projections 62 and the outer contact portions 63 and the outer contact regions 33R and 43R of the board shields 30 and 40 being in contact with each other via the projections 62 and the outer contact portions 63, noise can be prevented from leaking from the shielded spaces S1 and S2 formed above and under the circuit board 20, respectively.

In the following description, the positions of the mounting holes 37 and 47 of the board shields 30 and 40 into which the screw 52 is inserted and the position at which the projection 62 is provided are also referred to as outer contact points. In short, an outer contact point is, in the portion in which the outer contact regions 33L and 33R of the upper board shield 30 and the outer contact regions 43L and 43R of the lower board shield 40 face and overlap each other in the plan view, the point at which the upper board shield 30 is in contact with the lower board shield 40. The distance between adjacent two of the plurality of outer contact points provided in the outer contact regions 33L and 33R of the upper board shield 30 and the outer contact regions 43L and 43R of the lower board shield 40 is desirably determined on the basis of the wavelength of noise, the leakage of which to the outside is to be prevented, like the inner contact points.

In the outer contact regions 43L and 43R of the lower board shield 40, the projection 62 is located away from the mounting hole 37 in the extending direction of the outer contact regions 43L and 43R. Then, the distance between the mounting hole 37 and the projection 62 and the distance between the adjacent two projections 62 (that is, the distance between the adjacent two outer contact points) may be set to a value less than a third of the wavelength of noise that the board shields 30 and 40 shield, more preferably, less than a quarter of the wavelength. The distance between the mounting hole 37 and the projection 62 and the distance between the adjacent two projections 62 may each be set to 20 mm. In this manner, the leakage of noise in frequency bands that are used for wireless communications and the like can effectively be prevented. The distance between the mounting hole 37 and the projection 62 and the distance between the adjacent two projections 62 are each preferably 15 mm or less. The distance between the mounting hole 37 and the projection 62 and the distance between the adjacent two projections 62 are each further preferably 10 mm or less.

In FIG. 3A and FIG. 3B, the mounting holes 37 and 47 are indicated by the circles having substantially the same size, and the projections 62 are indicated by the circles (points) smaller than the mounting holes 37 and 47. As illustrated in FIG. 3A and FIG. 3B, the distance between every adjacent two of the outer contact points provided in the outer contact regions 33L, 33R, 43L, and 43R may be set to 20 mm or less. In this manner, noise can more effectively be prevented from leaking from the outer contact regions 33L, 33R, 43L, and 43R. The distance between every adjacent two outer contact points is preferably 15 mm or less. The distance between every adjacent two outer contact points is further preferably 10 mm or less.

As illustrated in FIG. 3A and FIG. 5, at least one projection 62 is formed between the two mounting holes 37 in the outer contact regions 43L and 43R of the lower board shield 40. Further, the single mounting hole 37 is formed between the two projections 62 in the outer contact regions 43L and 43R of the lower board shield 40. Note that the number of the mounting holes 37 that are placed between the two projections 62 may be two or more.

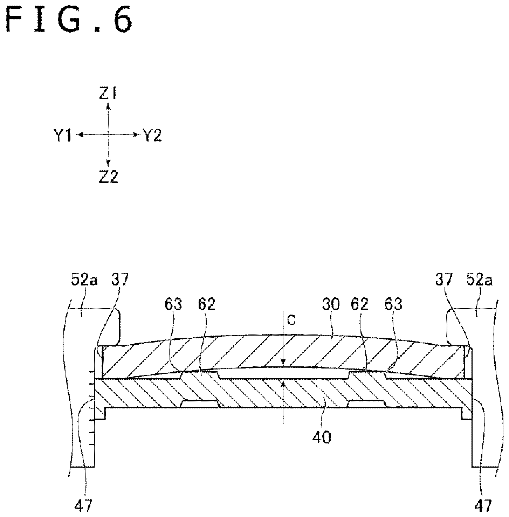

FIG. 6 is a schematic diagram of the cross sections of the outer contact regions 33L, 33R, 43L, and 43R of the upper board shield 30 and the lower board shield 40, illustrating the schematic cross sections of the cut surfaces along the extending direction of the ground patterns 22U and 22D. As illustrated in FIG. 6, the upper board shield 30 is pressed against the lower board shield 40 by heads 52a of the screws 52 at the positions of the mounting holes 37 to be in contact with the lower board shield 40. Then, with the warp relative to the lower board shield 40, the outer contact portions 63 of the upper board shield 30 are in contact with the projections 62. Thus, the upper board shield 30 desirably warps more easily than the lower board shield 40 having the projections 62 formed thereon. For example, the upper board shield 30 may be formed of a material different from the material of the lower board shield 40. The upper board shield 30 may be formed of a material softer (lower in rigidity) than the material of the lower board shield 40. For example, the upper board shield 30 may be formed of aluminum softer than iron that is the material of the lower board shield 40. Further, the thicknesses in the up-down direction of the upper board shield 30 of at least the outer contact regions 33L and 33R of the upper board shield 30 may be smaller than the thickness of the lower board shield 40.

As illustrated in FIG. 6, the upper board shield 30 warps upward with the outer contact portions 63 pushed up by the projections 62 of the lower board shield 40. With this, a gap C is formed between the two projections 62 in some cases. Here, on the lower board shield 40, when the number of the projections 62 that are formed between the two mounting holes 47 is three, the projection 62 between two of these three projections 62 may be placed near the gap C. Thus, as illustrated in FIG. 3A, on the lower board shield 40, the number of the projections 62 that are placed between the two mounting holes 47 is desirably two or less. In other words, in the outer contact regions 33L and 33R of the upper board shield 30, the number of the outer contact portions 63 that are in contact with the projection 62 provided between the two mounting holes 37 is desirably two or less. Further, on the upper ground pattern 22U of the circuit board 20, the number of the projections 61U (the number of the inner contact portions 38) that are placed between the two mounting holes 26 is also desirably two or less. As illustrated in FIG. 3B, on the lower ground pattern 22D of the circuit board 20, the number of the projections 61D (the number of the inner contact portions 48) that are placed between the two mounting holes 26 is also desirably two or less. In this manner, the upper board shield 30 is in contact with the lower board shield 40 with enough stability, so that enhanced shielding performance for noise generated on the circuit board 20 can be provided.

As illustrated in FIG. 3A and FIG. 3B, in the outer contact regions 33L, 33R, 43L, and 43R, the number of the projections 62 (the number of the outer contact portions 63) that are placed between the adjacent two mounting holes 37 or 47 is two or less. Further, in the inner contact regions 32F and 32B, the number of the projections 61U (the number of the inner contact portions 38) that are placed between the adjacent two mounting holes 36 is also two or less, and in the inner contact regions 42F and 42B, the number of the projections 61D (the number of the inner contact portions 48) that are placed between the adjacent two mounting holes 46 is also two or less. With this, noise can effectively be prevented from leaking from the regions surrounding the electronic components.

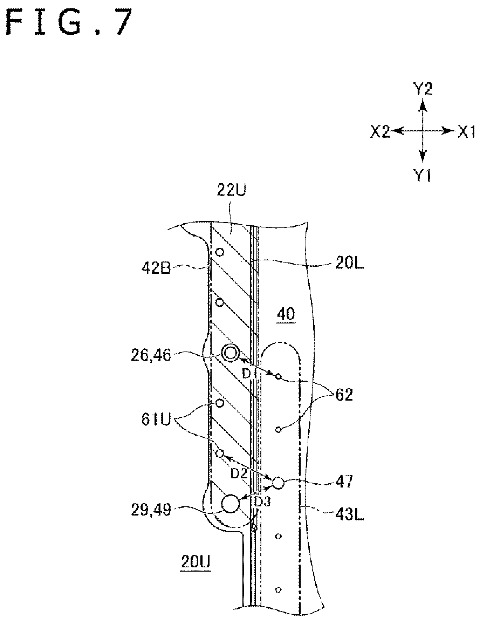

FIG. 7 is a partial enlarged view of FIG. 3A and a view illustrating the upper ground pattern 22U of the circuit board 20 and the outer contact region 43L of the lower board shield 40. As illustrated in FIG. 7, the mounting holes 26 formed in the upper ground pattern 22U of the circuit board 20 and the projections 62 formed in the outer contact region 43L of the lower board shield 40 are located on the opposite sides across the left edge 20L of the circuit board 20. Further, the mounting holes 36 (see FIG. 3B) formed in the inner contact region 32B (see FIG. 1A) of the upper board shield 30 and the mounting holes 46 formed in the inner contact region 42B (see FIG. 1B) of the lower board shield 40 are placed at the same positions as the mounting holes 26 formed in common to the upper and lower ground patterns 22U and 22D. Thus, with the upper board shield 30 overlapping the circuit board 20 and the lower board shield 40 illustrated in FIG. 7, the mounting holes 26, 36, and 46 formed in the inner contact regions 32B and 42B and the projections 62 formed in the outer contact region 43L (the outer contact portions 63 in the outer contact region 33L) are located on the opposite sides across the left edge 20L of the circuit board 20.

Here, a distance D1 from the mounting holes 26, 36, and 46 formed in the inner contact regions 32B and 42B to the closest projection 62 (outer contact portion 63) located on the opposite side across the left edge 20L of the circuit board 20 may be set to a value less than a third of the wavelength of noise that the board shields 30 and 40 shield, more preferably, less than a quarter of the wavelength. Further, the distance D1 may be set to 20 mm or less, more preferably, 15 mm or less or 10 mm or less. Further, the number of the projections 62 that are formed between the mounting holes 26, 36, and 46 and the closest mounting hole 47 located on the opposite side across the left edge 20L of the circuit board 20 is preferably two or less. In such a case, the distances from the mounting holes 26, 36, 46, and 47 to the projection 62 and the distance between the projections 62 may each be set to a value less than a third of the wavelength of noise that the board shields 30 and 40 shield, more preferably, less than a quarter of the wavelength. Further, the distances may each be set to 20 mm or less, more preferably, 15 mm or less or 10 mm or less. In this manner, noise can be shielded at the boundary between the inner contact region 32B and the outer contact region 33L of the upper board shield 30 and the boundary between the inner contact region 42B and the outer contact region 43L of the lower board shield 40.

Further, as illustrated in FIG. 7, the mounting holes 47 formed in the outer contact region 43L of the lower board shield 40 and the projections 61U formed on the upper ground pattern 22U are located on the opposite sides across the left edge 20L of the circuit board 20. Further, the mounting holes 37 (see FIG. 3B) formed in the outer contact region 33L (see FIG. 1A) of the upper board shield 30 are placed at the same positions as the mounting holes 47 formed in the lower board shield 40. Thus, the mounting holes 37 and 47 formed in the outer contact regions 33L and 43L and the projections 61U formed on the upper ground pattern 22U are located on the opposite sides across the left edge 20L of the circuit board 20. Further, the mounting holes 37 and 47 and the inner contact portions 38 (see FIG. 4) of the upper board shield 30 in contact with the upper ground pattern 22U via the projections 61U are located on the opposite sides across the left edge 20L of the circuit board 20. Similarly, the mounting holes 37 and 47 may be located on the opposite side of the projections 61D of the lower ground pattern 22D and the inner contact portions 48 of the lower board shield 40 in contact with the projections 61D, across the left edge 20L of the circuit board 20.

Here, a distance D2 between the mounting holes 37 and 47 formed in the outer contact regions 33L and 43L and the projection 61U formed on the upper ground pattern 22U (the inner contact portion 38 of the upper board shield 30) may be set to a value less than a third of the wavelength of noise that the board shields 30 and 40 shield, more preferably, less than a quarter of the wavelength, like the distance D1. Further, the distance D2 may be set to 20 mm or less, more preferably, 15 mm or less or 10 mm or less. Further, the distance between the mounting holes 37 and 47 and the projection 61D formed on the lower ground pattern 22D (the contact portion 48 of the lower board shield 40) may also be set to a value less than a third of the wavelength of noise that the board shields 30 and 40 shield, more preferably, less than a quarter of the wavelength. The distance may be set to 20 mm or less, more preferably, 15 mm or less or 10 mm or less. Also in this case, noise can be shielded at the boundary between the inner contact region 32B and the outer contact region 33L of the upper board shield 30 and the boundary between the inner contact region 42B and the outer contact region 43L of the lower board shield 40.

Further, as illustrated in FIG. 7, the circuit board 20 and the lower board shield 40 have formed therein holes 29 and 49 for temporarily fixing the circuit board 20 to the lower board shield 40 in the manufacturing process of the circuit board unit 10. Here, the holes 29 and 49 are regarded as the mounting holes 29 and 49, and the mounting hole 36 of the upper board shield 30 is formed at the position corresponding to the mounting holes 29 and 49. With the single screw 51 being inserted into the mounting holes 36, 29, and 49, the circuit board 20 may be in contact with the board shields 30 and 40 at the positions of the mounting holes 36, 29, and 49. Then, a distance D3 between the mounting holes 36, 29, and 49 and the mounting holes 37 and 47 may be set to a value less than a third of the wavelength of noise that the board shields 30 and 40 shield, more preferably, less than a quarter of the wavelength, like the distance D1. Further, the distance D3 may be set to 20 mm or less, more preferably, 15 mm or less or 10 mm or less. Also in this case, noise can be shielded at the boundary between the inner contact region 42B and the outer contact region 43L.

Further, the above-mentioned noise shielding structure at the boundary between the inner contact region 32B and the outer contact region 33L of the upper board shield 30 may also be formed at the boundary between the inner contact region 32F and the outer contact region 33L, the boundary between the inner contact region 32B and the outer contact region 33R, and the boundary between the inner contact region 32F and the outer contact region 33R. In this manner, on the upper surface 20U of the circuit board 20, noise can be shielded at both the boundaries between the inner contact regions 32F and 32B surrounding the upper mounting region R1, in which the plurality of electronic components that are noise generation sources are mounted, and the outer contact regions 33L and 33R. That is, noise can be shielded in the regions continuously surrounding the upper mounting region R1. Further, the noise shielding structure at the boundary between the inner contact region 42B and the outer contact region 43L of the lower board shield 40 may also be formed at the boundary between the inner contact region 42F and the outer contact region 43L, the boundary between the inner contact region 42B and the outer contact region 43R, and the boundary between the inner contact region 42F and the outer contact region 43R. In this manner, on the lower surface 20D of the circuit board 20, noise can be shielded at both the boundaries between the inner contact regions 42F and 42B surrounding the lower mounting region R2, in which the plurality of electronic components that are noise generation sources are mounted, and the outer contact regions 43L and 43R. That is, noise can be shielded in the regions continuously surrounding the lower mounting region R2.

### [5. Conclusion]

As described above, in the present embodiment, the inner contact regions 32F and 32B of the upper board shield 30 are in contact with the upper ground pattern 22U of the circuit board 20, and the inner contact regions 42F and 42B of the lower board shield 40 are in contact with the lower ground pattern 22D of the circuit board 20. Then, the outer contact region 33L of the upper board shield 30 is in contact with the outer contact region 43L of the lower board shield 40, and the outer contact region 33R of the upper board shield 30 is in contact with the outer contact region 43R of the lower board shield 40. With the outer contact regions 33L, 33R, 43L, and 43R having the mounting holes 37 and 47 and the projections 62, the outer contact regions 33L and 33R of the board shield 30 are in contact with the outer contact regions 43L and 43R of the board shield 40. In this manner, noise generated on the circuit board 20 can be prevented from leaking to the outside of the circuit board unit 10. Further, the regions for shielding noise can be provided outside the circuit board 20, so that the ground patterns 22U and 22D inside the circuit board 20 can have narrowed regions. As a result, the circuit board 20 can have an expanded area in which the electronic components and the like are mounted, or the compact circuit board 20 can be provided.

Note that the present disclosure is not limited to the embodiment described above.
(1) In the example described in the embodiment, as the noise shielding structure outside the circuit board 20, the outer contact regions 43L and 43R of the lower board shield 40 have the plurality of projections 62 protruding upward, and the outer contact regions 33L and 33R of the upper board shield 30 are in contact with the projections 62. The present disclosure is not limited to this, and the outer contact regions 33L and 33R of the upper board shield 30 may have the plurality of projections 62 protruding downward, and the outer contact regions 43L and 43R of the lower board shield 40 may be in contact with the projections 62. Also in this case, the upper board shield 30 is contact with the lower board shield 40 at the positions of the projections 62, so that enhanced shielding performance for noise generated on the circuit board 20 can be provided.
(2) In the example described in the embodiment, the upper encompassing region 31 of the upper board shield 30 has the inner contact regions 32F and 32B located on the inner sides of the outer edges of the circuit board 20 and the outer contact regions 33L and 33R located on the outer sides of the outer edges of the circuit board 20, and these contact regions surround the entire periphery of the region in which the electronic components are placed on the upper surface 20U of the circuit board 20. In an example not covered by the claimed invention, on the board shields 30 and 40, the outer contact regions located on the outer sides of the outer edges of the circuit board 20 may surround the entire outer peripheral edge of the circuit board 20. In this manner, noise can be prevented from leaking to the outside of the circuit board 20 without forming the ground patterns 22U and 22D inside the circuit board 20.
(3) In the example described in the embodiment, the upper board shield 30 has the two regions, namely, the outer contact regions 33L and 33R, and the lower board shield 40 has the two regions, namely, the outer contact regions 43L and 43R. The number of outer contact regions that the board shields 30 and 40 have may, however, be one. Further, in the outer contact regions where the board shields 30 and 40 are in contact with each other, the number of the mounting holes 37 and the number of the mounting hole 47 may be one, and the number of the projections 62 may also be one. Also in such an example, the region for shielding noise can be provided outside the circuit board 20, so that the ground patterns 22U and 22D inside the circuit board 20 can have narrowed regions.

It should be understood by those skilled in the art that various modifications, combinations, sub-combinations and alterations may occur depending on design requirements and other factors insofar as they are within the scope of the appended claims.

## Claims

1. An electronic device comprising:
a circuit board (20) having a first surface (20U) and a second surface (20D);
a first member (30) for covering the first surface to function as a shield of the circuit board; and
a second member (40) placed on a side of the second surface,
wherein the first member has a first encompassing region (31) surrounding an electronic component mounted on the first surface,
the first encompassing region has, in at least a portion thereof, a first outer region (33L, 33R) located on an outer side of an outer edge of the circuit board,
the second member has a second outer region (43L, 43R) located on the outer side of the outer edge of the circuit board,
one of the first outer region and the second outer region has at least one outer fixed portion (37, 47) fixed to another of the first outer region and the second outer region and at least one projection (62) located away from the at least one outer fixed portion in a direction along the outer edge of the circuit board,
the first member and the second member are in contact with each other with the at least one outer fixed portion and the at least one projection, and
the first encompassing region has, in at least a portion thereof, a first inner region (32F, 32B) located on an inner side of another outer edge of the circuit board, wherein the first inner region is in contact with a ground pattern (22U) formed on the first surface of the circuit board, and wherein the first inner region has at least one inner fixed portion (36) for fixing to the circuit board.

2. The electronic device according to claim 1,
wherein the second member is a member for covering the second surface to function as a shield of the circuit board and has a second encompassing region (41) surrounding an electronic component mounted on the second surface, and
the second encompassing region has, in at least a portion thereof, the second outer region.

3. The electronic device according to claim 1, wherein the first inner region has at least one inner contact portion being located away from the at least one inner fixed portion in an extending direction of the first encompassing region and being in contact with the ground pattern.

4. The electronic device according to claim 3,
wherein the at least one outer fixed portion and the at least one projection form a contact point between the first member and the second member,
the at least one inner fixed portion and the at least one inner contact portion form a contact point between the first member and the ground pattern, and
a distance between two of the contact points adjacent to each other across the outer edge of the circuit board is 20 mm or less.

5. The electronic device according to claim 1, wherein the at least one projection is formed by sheet metal processing.

6. The electronic device according to claim 1,
wherein one of the first outer region and the second outer region further has a projection, and
the at least one outer fixed portion is formed between two of the projections.

7. The electronic device according to claim 1,
wherein one of the first outer region and the second outer region further has an outer fixed portion, and
the at least one projection is formed between two of the outer fixed portions.

8. The electronic device according to claim 7,
one of the first outer region and the second outer region further has a projection, and
two or less of the projections are formed between the two outer fixed portions.

9. The electronic device according to claim 1, wherein a distance between the at least one outer fixed portion and the at least one projection is 20 mm or less.

10. The electronic device according to claim 3,
wherein the first outer region further has an outer fixed portion and a projection,
two or less of the projections are formed between adjacent two of the outer fixed portions,
the first inner region has a plurality of inner fixed portions as the at least one inner fixed portion,
two or less of the inner contact portions are formed between adjacent two of the inner fixed portions as the at least one inner contact portion,
a plurality of the outer fixed portions and the two or less projections form a contact point between the first member and the second member,
a plurality of the inner fixed portions and the two or less inner contact portions form a contact point between the first member and the ground pattern, and
a distance between every adjacent two of the contact points is 20 mm or less.

11. The electronic device according to claim 2,
wherein the first encompassing region has a first inner region in contact with a ground pattern formed on the first surface of the circuit board, and
the second encompassing region has a second inner region in contact with a second ground pattern formed on the second surface of the circuit board.

12. The electronic device according to claim 11,
wherein the first inner region has
at least one first inner fixed portion fixed to the circuit board with a fixture, and
at least one first contact portion being located away from the at least one first inner fixed portion in an extending direction of the first encompassing region and being in contact with the ground pattern via a projection, and
the second inner region has
at least one second inner fixed portion fixed to the circuit board with the fixture, and
at least one second contact portion being located away from the at least one second inner fixed portion in an extending direction of the second encompassing region and being in contact with the ground pattern via a projection.

## Patentansprüche

1. Elektronische Vorrichtung, umfassend:
eine Schaltungsplatte (20), die eine erste Oberfläche (20U) und eine zweite Oberfläche (20D) aufweist;
ein erstes Element (30) zur Abdeckung der ersten Oberfläche, das als Abschirmung der Schaltungsplatte dient; und
ein zweites Element (40), das auf einer Seite der zweiten Oberfläche angeordnet ist,
wobei das erste Element eine erste umschließende Region (31) aufweist, die eine an der ersten Oberfläche befestigte elektronische Komponente umgibt,
die erste umschließende Region mindestens in einem Abschnitt davon eine erste äußere Region (33L, 33R) aufweist, die sich an einer Außenseite eines äußeren Randes der Schaltungsplatte befindet,
das zweite Element eine zweite äußere Region (43L, 43R) aufweist, die sich an der Außenseite der äußeren Kante der Schaltungsplatte befindet,
eine von der ersten äußeren Region und der zweiten äußeren Region mindestens einen äußeren festen Abschnitt (37, 47), der an einer anderen von der ersten äußeren Region und der zweiten äußeren Region befestigt ist, und mindestens einen Vorsprung (62) aufweist, der von dem mindestens einen äußeren festen Abschnitt in einer Richtung entlang des äußeren Randes der Schaltungsplatte entfernt angeordnet ist,
das erste Element und das zweite Element mit dem mindestens einen äußeren festen Abschnitt und dem mindestens einen Vorsprung miteinander in Kontakt stehen, und
die erste umschließende Region mindestens in einem Abschnitt davon eine erste innere Region (32F, 32B) aufweist, die auf einer Innenseite einer anderen äußeren Kante der Schaltungsplatte angeordnet ist, wobei die erste innere Region in Kontakt mit einem Erdungsmuster (22U) steht, das auf der ersten Oberfläche der Schaltungsplatte gebildet ist, und wobei die erste innere Region mindestens einen inneren festen Abschnitt (36) zur Befestigung an der Schaltungsplatte aufweist.

2. Elektronische Vorrichtung nach Anspruch 1,
wobei das zweite Element ein Element zum Abdecken der zweiten Oberfläche ist, um als Abschirmung der Schaltungsplatte zu fungieren, und eine zweite umschließende Region (41) aufweist, die eine an der zweiten Oberfläche befestigte elektronische Komponente umgibt, und
die zweite umschließende Region mindestens in einem Abschnitt die zweite äußere Region aufweist.

3. Elektronische Vorrichtung nach Anspruch 1, wobei die erste innere Region mindestens einen inneren Kontaktabschnitt aufweist, der in einer Erstreckungsrichtung der ersten umschließenden Region von dem mindestens einen inneren festen Abschnitt entfernt liegt und mit dem Erdungsmuster in Kontakt steht.

4. Elektronische Vorrichtung nach Anspruch 3,
wobei der mindestens eine äußere feste Abschnitt und der mindestens eine Vorsprung einen Kontaktpunkt zwischen dem ersten Element und dem zweiten Element bilden,
der mindestens eine innere feste Abschnitt und der mindestens eine innere Kontaktabschnitt einen Kontaktpunkt zwischen dem ersten Element und der Erdung bilden, und
der Abstand zwischen zwei nebeneinander liegenden Kontaktpunkten an der äußeren Kante der Schaltungsplatte 20 mm oder weniger beträgt.

5. Elektronische Vorrichtung nach Anspruch 1, wobei der mindestens eine Vorsprung durch Blechbearbeitung gebildet wird.

6. Elektronische Vorrichtung nach Anspruch 1,
wobei eine der ersten äußeren Region und der zweiten äußeren Region ferner einen Vorsprung aufweist, und
der mindestens eine äußere feste Abschnitt zwischen zwei der Vorsprünge gebildet wird.

7. Elektronische Vorrichtung nach Anspruch 1,
wobei eine der ersten äußeren Region und der zweiten äußeren Region ferner einen äußeren festen Abschnitt aufweist, und
der mindestens eine Vorsprung zwischen zwei der äußeren festen Abschnitte gebildet wird.

8. Elektronische Vorrichtung nach Anspruch 7,
eine der ersten äußeren Region und der zweiten äußeren Region ferner einen Vorsprung aufweist, und
zwei oder weniger der Vorsprünge zwischen den beiden äußeren festen Abschnitten gebildet werden.

9. Elektronische Vorrichtung nach Anspruch 1, wobei ein Abstand zwischen dem mindestens einen äußeren festen Abschnitt und dem mindestens einen Vorsprung 20 mm oder weniger beträgt.

10. Elektronische Vorrichtung nach Anspruch 3,
wobei die erste äußere Region ferner einen äußeren festen Abschnitt und einen Vorsprung aufweist,
zwei oder weniger der Vorsprünge zwischen zwei benachbarten äußeren festen Abschnitten gebildet werden,
die erste innere Region eine Vielzahl von inneren festen Abschnitten als mindestens einen inneren festen Abschnitt aufweist,
zwei oder weniger der inneren Kontaktabschnitte zwischen zwei benachbarten der inneren festen Abschnitte als mindestens ein innerer Kontaktabschnitt gebildet werden,
eine Vielzahl der äußeren festen Abschnitte und die zwei oder weniger Vorsprünge einen Kontaktpunkt zwischen dem ersten Element und dem zweiten Element bilden,
eine Vielzahl der inneren festen Abschnitte und die zwei oder weniger inneren Kontaktabschnitte einen Kontaktpunkt zwischen dem ersten Element und dem Erdungsmuster bilden, und
ein Abstand zwischen jeweils zwei benachbarten Kontaktpunkten 20 mm oder weniger beträgt.

11. Elektronische Vorrichtung nach Anspruch 2,
wobei die erste umschließende Region eine erste innere Region aufweist, die in Kontakt mit einem auf der ersten Oberfläche der Schaltungsplatte gebildeten Erdungsmuster steht, und
die zweite umschließende Region eine zweite innere Region aufweist, die in Kontakt mit einem zweiten Erdungsmuster steht, das auf der zweiten Oberfläche der Schaltungsplatte gebildet ist.

12. Elektronische Vorrichtung nach Anspruch 11,
wobei die erste innere Region Folgendes aufweist
mindestens einen ersten inneren festen Abschnitt, der mit einer Halterung an der Schaltungsplatte befestigt ist, und
mindestens einen ersten Kontaktabschnitt, der von dem mindestens einen ersten inneren festen Abschnitt in einer Erstreckungsrichtung der ersten umschließenden Region entfernt ist und über einen Vorsprung mit dem Erdungsmuster in Kontakt steht, und
die zweite innere Region Folgendes aufweist
mindestens einen zweiten inneren festen Abschnitt, der mit der Halterung an der Schaltungsplatte befestigt ist, und
mindestens einen zweiten Kontaktabschnitt, der von dem mindestens einen zweiten inneren festen Abschnitt in einer Erstreckungsrichtung der zweiten umschließenden Region entfernt ist und über einen Vorsprung mit dem Erdungsmuster in Kontakt steht.

## Revendications

1. Dispositif électronique comprenant :
une carte de circuit imprimé (20) ayant une première surface (20U) et une seconde surface (20D) ;
un premier élément (30) pour recouvrir la première surface pour agir comme un blindage de la carte de circuit imprimé ; et
un second élément (40) placé sur un côté de la seconde surface,
dans lequel le premier élément a une première région englobante (31) entourant un composant électronique monté sur la première surface,
la première région englobante a, dans au moins une partie de celle-ci, une première région extérieure (33L, 33R) située sur un côté extérieur d'un bord extérieur de la carte de circuit imprimé,
le second élément a une seconde région extérieure (43L, 43R) située sur le côté extérieur du bord extérieur de la carte de circuit imprimé,
l'une parmi la première région extérieure et la seconde région extérieure a au moins une partie fixe extérieure (37, 47) fixée à une autre parmi la première région extérieure et la seconde région extérieure et au moins une saillie (62) située à distance de l'au moins une partie fixe extérieure dans une direction le long du bord extérieur de la carte de circuit imprimé,
le premier élément et le second élément sont en contact l'un avec l'autre avec l'au moins une partie fixe extérieure et l'au moins une saillie, et
la première région englobante a, dans au moins une partie de celle-ci, une première région intérieure (32F, 32B) située sur un côté intérieur d'un autre bord extérieur de la carte de circuit imprimé, dans lequel la première région intérieure est en contact avec un motif de masse (22U) formé sur la première surface de la carte de circuit imprimé, et dans lequel la première région intérieure a au moins une partie fixe intérieure (36) pour la fixation à la carte de circuit imprimé.

2. Dispositif électronique selon la revendication 1,
dans lequel le second élément est un élément permettant de recouvrir la seconde surface pour agir comme un blindage de la carte de circuit imprimé et a une seconde région englobante (41) entourant un composant électronique monté sur la seconde surface, et
la seconde région englobante a, dans au moins une partie de celle-ci, la seconde région extérieure.

3. Dispositif électronique selon la revendication 1, dans lequel la première région intérieure a au moins une partie de contact intérieure étant située à l'écart de l'au moins une partie fixe intérieure dans une direction d'extension de la première région englobante et étant en contact avec le motif de masse.

4. Dispositif électronique selon la revendication 3,
dans lequel l'au moins une partie fixe extérieure et l'au moins une saillie forment un point de contact entre le premier élément et le second élément,
l'au moins une partie fixe intérieure et l'au moins une partie de contact intérieure forment un point de contact entre le premier élément et le motif de masse, et
une distance entre deux des points de contact adjacents l'un à l'autre sur le bord extérieur de la carte de circuit imprimé est de 20 mm ou moins.

5. Dispositif électronique selon la revendication 1, dans lequel l'au moins une saillie est formée par traitement de tôle.

6. Dispositif électronique selon la revendication 1,
dans lequel l'une parmi la première région extérieure et la seconde région extérieure a en outre une saillie, et
l'au moins une partie fixe extérieure est formée entre deux des saillies.

7. Dispositif électronique selon la revendication 1,
dans lequel l'une parmi la première région extérieure et la seconde région extérieure a en outre une partie fixe extérieure, et
l'au moins une saillie est formée entre deux des parties fixes extérieures.

8. Dispositif électronique selon la revendication 7,
l'une parmi la première région extérieure et la seconde région extérieure a en outre une saillie, et
deux des saillies ou moins sont formées entre les deux parties fixes extérieures.

9. Dispositif électronique selon la revendication 1, dans lequel une distance entre l'au moins une partie fixe extérieure et l'au moins une saillie est de 20 mm ou moins.

10. Dispositif électronique selon la revendication 3,
dans lequel la première région extérieure a en outre une partie fixe extérieure et une saillie,
deux ou moins des saillies sont formées entre deux des parties fixes extérieures adjacentes,
la première région intérieure a une pluralité de parties fixes intérieures en tant que l'au moins une partie fixe intérieure,
deux ou moins des parties de contact intérieures sont formées entre deux des parties fixes intérieures adjacentes en tant que l'au moins une partie de contact intérieure,
une pluralité des parties fixes extérieures et les deux saillies ou moins forment un point de contact entre le premier élément et le second élément,
une pluralité des parties fixes intérieures et les deux parties de contact intérieures ou moins forment un point de contact entre le premier élément et le motif de masse, et
une distance entre tous les deux points de contact adjacents est de 20 mm ou moins.

11. Dispositif électronique selon la revendication 2,
dans lequel la première région englobante a une première région intérieure en contact avec un motif de masse formé sur la première surface de la carte de circuit imprimé, et
la seconde région englobante a une seconde région intérieure en contact avec un second motif de masse formé sur la seconde surface de la carte de circuit imprimé.

12. Dispositif électronique selon la revendication 11,
dans lequel la première région intérieure a
au moins une première partie fixe intérieure fixée à la carte de circuit imprimé avec un élément de fixation, et
au moins une première partie de contact étant située à distance de l'au moins une première partie fixe intérieure dans une direction d'extension de la première région englobante et étant en contact avec le motif de masse par l'intermédiaire d'une projection, et
la seconde région intérieure a
au moins une seconde partie fixe intérieure fixée à la carte de circuit imprimé avec l'élément de fixation, et
au moins une seconde partie de contact étant située à distance de l'au moins une seconde partie fixe intérieure dans une direction d'extension de la seconde région englobante et étant en contact avec le motif de masse par l'intermédiaire d'une projection.
